# EUROPÄISCHE PATENTANMELDUNG

(11) **EP 2 039 460 A2**
(43) Veröffentlichungstag der Anmeldung: **25.03.2009**
(21) Anmeldenummer: 08170034.6
(22) Anmeldetag: 27.10.2005
(51) Int. Cl.: B23K 20/10, B23K 20/00, H05K 13/06, H01L 21/60

(54) **Verlegevorrichtung, Kontaktiervorrichtung, Zustellsystem, Verlege- und Kontaktiereinheit, herstellungsanlage, Verfahren zur Herstellung und eine Transpondereinheit**

(30) Priorität: 02.11.2004 DE 102004053388; 20.06.2005 DE 102005028467
(62) Teilanmeldung aus: 08157620.9
(71) Anmelder: HID Global GmbH, 65396 Walluf (DE)
(72) Erfinder: Lang, Ulrich, 87616 Marktoberdorf (DE)
(74) Vertreter: Grosfillier, Philippe

(57) **Zusammenfassung**

Offenbart ist eine Verlegevorrichtung zum Verlegen von Drahtwicklungen bei Transpondereinheiten mit einer axialen Drahtzuführung zur Verlegevorrichtung, eine Kontaktiervorrichtung zum Kontaktieren der Drähte mit einer selbsttätigen Thermodenklemmanordnung, ein Zustellsystem zum Zustellen von Bearbeitungsvorrichtungen mit einem Piezo-Leg-Motor, eine Herstellungsanlage zur Herstellung von Transpondereinheiten in Konsolenbauweise, ein Verfahren zur Herstellung von Transpondereinheiten mit horizontaler Ultraschalleinleitung und eine Transpondereinheit, bei der die Drahtenden direkt an den Anschlussflächen des Chips angreifen.

## Beschreibung

Die Erfindung betrifft eine Verlegevorrichtung zum Verlegen von Drahtwicklungen bei Transpondereinheiten, insbesondere zur Herstellung von Chipkarten, nach dem Oberbegriff des Patentanspruchs 1, eine Kontaktiervorrichtung zum Kontaktieren der Drähte nach dem Oberbegriff des Patentanspruchs 20, ein Zustellsystem zum Zustellen von Bearbeitungsvorrichtungen nach dem Oberbegriff des Patentanspruchs 30, eine Verlege- und Kontaktiereinheit nach dem Patentanspruch 35, eine Herstellungsanlage zur Herstellung von Transpondereinheiten nach dem Oberbegriff des Patentanspruchs 38, ein Verfahren zur Herstellung von Transpondereinheiten nach dem Oberbegriff des Patentanspruch 55 und eine Transpondereinheit nach dem Oberbegriff des Patentanspruchs 60.

Transpondereinheiten werden zum Beispiel bei Chipkarten wie biometrischen Pässen, verwendet. Sie dienen zum Speichern und Übertragen von Informationen und bestehen im wesentlichen aus einer Drahtspule, die sich aus einzelnen Drahtwicklungen zusammensetzt, und mit ihren Endabschnitten mit einem Chip verbunden ist. Die Drahtspule dient als Antenne zur Übertragung und von Informationen auf dem Chip. Üblicherweise ist die Transpondereinheit unmittelbar in ein Substrat eingebracht. Das Einbetten des Drahtes in das Substrat bzw. das Verbinden deren Endabschnitte mit dem Chip erfolgt über Ultraschallbeaufschlagung oder thermischen Schweißen.

Bei bekannten Chipkarten sind die Chips auf einem Chipmodul zur Vergrößerung ihrer Anschlussflächen angeordnet und über dieses auf dem Substrat positioniert.

An derartigen Chipkarten ist nachteilig, dass durch die Chipmodule im wesentlichen die Materialkosten erhöht werden.

Eine Vorrichtung zur Herstellung einer derartigen Chipkarte ist in der EP 0 880 754 B1 gezeigt. Die Verlegevorrichtung hat eine Sonotrode und einen Ultraschallkonverter zur Beaufschlagung eines in der Sonotrode geführten isolierten Drahtes mit Ultraschallschwingungen. Durch die Schwingungen wird der Draht mit seiner Isolierung erhitzt und beim Verlegen quasi in das Substrat "eingehämmert".

Nachteilig an dieser Lösung ist, dass der Draht seitlich in die Sonotrode eingeführt wird, wodurch eine Schrägbohrung zur Aufnahme des Drahtes in der Sonotrode ausgebildet sein muss und die Sonotrode eine aufwendige Geometrie aufweist. Dabei erfolgt die Einfädelung des Drahtes in die Schrägbohrung manuell, was entsprechend zeit- und kostenintensiv ist.

Eine bekannte Kontaktiervorrichtung zum Verbinden der Endabschnitte des Drahtes mit dem Chip weist eine Thermode auf, die erhitzt und gegen die Endabschnitte gedrückt wird, so dass durch Temperatur- und Druckbeaufschlagung des Drahtes diese mit dem Chip verschweißt werden. Dabei ist die Thermode zwischen Klemmkörpern angeordnet, die mittels Klemmschrauben miteinander verspannt sind.

Nachteilig an dieser Lösung ist, dass zum Wechseln der Thermode die Klemmschrauben manuell gelöst werden müssen.

Zum Zustellen einer Verlegevorrichtung bzw. Kontaktiervorrichtung werden üblicherweise Spindelmotoren verwendet, die zur Dämpfung von Überschwingungen der Motoren über Dämpfungselemente mit der jeweiligen Vorrichtung verbunden sind.

Spindelmotoren weisen jedoch eine begrenzte Dynamik auf. Zusätzlich werden über die Dämpfungselemente unerwünschte Schwingungen in das Zustellsystem eingeleitet. Ferner benötigen Spindelmotoren einen separaten Bremsmechanismus, um ungewollte Verschiebungen in vertikaler Richtung aufgrund der Schwerkraft zu verhindern.

Gemäß der EP 0 880 754 B1 werden bei bekannten Verfahren zur Herstellung von Chipkarten die Drähte beim Verlegen auf dem Substrat mit vertikalen Ultraschallschwingungen beaufschlagt. D.h. die Ultraschallschwingungen verlaufen in Längsrichtung der, den Draht führenden Sonotrode.

Nachteilig an diesen Verfahren ist jedoch, dass Verschmutzungen, zum Beispiel der Drahtisolierung, mit in das Substrat "eingehämmert" werden können.

Zur industriellen Herstellung von Chipkarten werden mehrere Verlegevorrichtungen und Kontaktiervorrichtungen in einer Herstellungsanlage zusammengefasst. Derartige Anlagen sind meist in Portalbauweise aufgebaut. Eine bekannte Portalbauweise ist in der EP 0 880 754 B1 offenbart. Die Portale weisen im wesentlichen zwei an entgegengesetzten Längsseiten eines Maschinenbettes positionierte Vertikalstützen und einen, die Vertikalstützen miteinander verbindenden Querträger auf. Die Vorrichtungen sind gemäß der Reihenfolge der Arbeitsschritte in Gruppen sortiert an den Querträgern nebeneinander angeordnet und über eine Vertikalbewegung des Querträgers in vertikaler Richtung zustellbar.

Die Portalbauweise hat den Nachteil, dass die Zugänglichkeit und somit die Beobachtbarkeit des Herstellungsprozesses aufgrund der Vertikalstützen stark eingeschränkt ist. Weiterhin ist nachteilig, dass ein an den Querträgern zur Befestigung der Bearbeitungsvorrichtungen zur Verfügung stehender Raum stark begrenzt ist, so dass die Produktivität stark begrenzt ist.

Aufgabe der vorliegenden Erfindung ist es, eine Verlegevorrichtung zur Verlegung von Drähten einer Transpondereinheit, eine Kontaktiervorrichtung zur Kontaktierung der Drähte, ein Zustellsystem zum Zustellen von Bearbeitungsvorrichtungen, eine Verlege- und Kontaktiereinheit, eine Herstellungsanlage zur Herstellung von Transpondereinheiten, ein Verfahren zur Herstellung von Transpondereinheiten und Transpondereinheit zu schaffen, die die vorgenannten Nachteile beseitigen und eine sichere und kostengünstige Fertigung erlauben.

Diese Aufgabe wird gelöst durch eine Verlegevorrichtung mit den Merkmalen nach dem Patentanspruch 1, eine Kontaktiervorrichtung mit den Merkmalen nach dem Patentanspruch 20, eine Zustellsystem mit den Merkmalen nach dem Patentanspruch 30, eine Verlege- und Kontaktiereinheit mit den Merkmalen nach dem Patentanspruch 35, eine Herstellungsanlage mit den Merkmalen nach dem Patentanspruch 38, ein Verfahren mit den Merkmalen nach dem Patentanspruch 55 und eine Transpondereinheit mit den Merkmalen nach dem Patentanspruch 60.

Eine erfindungsgemäße Verlegevorrichtung hat eine Sonotrode zur Verlegung des Drahtes auf einem Substrat und einen Ultraschallkonverter zur Beaufschlagung der Sonotrode mit Ultraschallschwingungen. Erfindungsgemäß ist der Draht axial der Verlegevorrichtung zuführbar.

Die axiale Drahtzuführung hat den Vorteil, dass keine Schrägbohrung in der Sonotrode ausgebildet sein muss und die Sonotrode entsprechend einfach ausführbar ist. Durch den vereinfachten Aufbau der Sonotrode kann ihr Gewicht reduziert werden, was eine Erhöhung der Ultraschallschwingungen, zum Beispiel von üblichen 40 kHz auf etwa 60 kHz, erlaubt.

Eine bevorzugte Ausführungsform sieht einen axialen Durchgangskanal zur Aufnahme des Drahtes vor, der die Verlegevorrichtung axial durchsetzt.

Um die Reibung des Drahtes in dem Durchgangskanal zu minimieren, kann der Draht via einer Luftlagerung in dem Durchgangskanal geführt sein. Hierzu kann in einem Drahteinführungsbereich des Durchgangskanals eine Radialbohrung zum Einblasen von Pressluft vorgesehen sein. Dabei kann es vorteilhaft sein, die Pressluft auf etwa 50°C bis 60°C zu erwärmen, um eine Vorerwärmung des Draht bzw. seiner Isolierung zu erzielen und die Taktzeit zum Verlegen zu verkürzen.

Eine Ausführungsform sieht zur Verbesserung der Luftlagerung vor, den Durchgangskanal im Kopfbereich der Sonotrode radial zu verjüngen, um eine Art Staudruck auszubilden. Beträgt zum Beispiel der Durchmesser des Durchgangskanals 3 mm, so ist er im Kopfbereich bevorzugterweise auf einer axialen Länge von etwa 2 mm bis 3 mm von seiner Austrittsöffnung aus gemessen auf etwa 300 µm reduziert.

Um einen Verschleiß der Sonotrode an der Ausgangsöffnung zu minimieren, ist es vorteilhaft, wenn die Sonotrode drehbar in der Verlegevorrichtung gelagert ist, so dass der Draht nicht an einem lokalen Bereich der Austrittsöffnung anliegt, sondern mit einer Vielzahl von lokalen Bereichen in Berührung tritt, so dass im Betrieb der gesamte Umfangsbereich der Austrittsöffnung abschnittsweise gleichmäßig belastet ist. Derartige Drehbewegungen lassen sich dadurch erreichen, dass der Ultraschallkonverter schwimmend, vorzugsweise mittels aerostatischer Führung, gelagert ist. Dabei kann der Ultraschallkonverter mit zwei Ringschultern ausgebildet sein, die einen mit Pressluft, bevorzugterweise im Bereich von etwa 6 bar, zu baufschlagenden Ringraum begrenzen.

Um ein Zuführen des Drahtes zum Durchgangskanal zu automatisieren kann eine Vorschubeinrichtung vorgesehen sein, die den einzuführenden Endabschnitt des Drahts ergreift und in den Durchgangskanal einführt bzw. einfädelt. Dabei sieht eine Ausführungsform vor, die Vorschubeinrichtung greiferartig und relativ verfahrbar zur Verlegevorrichtung auszuführen.

Der Ultraschallkonverter kann grundsätzlich beliebig zur Sonotrode angeordnet sein. Bei einer Ausführungsform ist er mit seiner Längsachse koaxial zur Längsachse der Sonotrode positioniert, wobei sich der Durchgangskanal durch ihn erstreckt. Bei einer anderen Ausführungsform ist er seitlich zur Sonotrode angeordnet. Die seitliche Anordnung hat den Vorteil, dass die Sonotrode noch leichter ausführbar ist und somit die Verlegevorrichtung mit noch höheren Frequenzen, zum Beispiel jenseits von 100 kHz, betrieben werden kann. Dabei erfolgt bei der seitlichen Anordnung die Einleitung der Ultraschallwellen in die Sonotrode bevorzugterweise quer zu ihrer Längsachse, d.h. in horizontaler Richtung.

Bei einer bevorzugten Ausführungsform ist die Längsachse des Ultraschallkonverters um einen Versatz radial versetzt zur Längsachse eines den Ultraschallkonverter lagernden Gehäuses angeordnet.

Bei einer anderen bevorzugten Ausführungsform kann der Draht von seiner Isolierung innerhalb der Verlegevorrichtung befreit werden.

Eine erfindungsgemäße Kontaktiervorrichtung zum Kontaktieren von Drähten, insbesondere mit Chips, hat eine Klemmanordnung zum Klemmen einer Thermode. Erfindungsgemäß hat die Klemmanordnung Klemmbacken, die selbsttätig gegeneinander vorgespannt sind, so dass die Thermode eingeklemmt ist.

Vorteilhaft an dieser Lösung ist, dass die manuell zu betätigenden Klemmschrauben entfallen.

Bei einer bevorzugten Ausführungsform hat die Klemmanordnung eine feststehende und eine bewegbare Klemmbacke, wobei die bewegbare Klemmbacke hebelartig ausgebildet und über eine Feder gegen die feststehende Klemmbacke vorgespannt ist. Vorzugsweise stützt sich die Feder an der feststehenden Klemmbacke ab.

Zum Lösen der Klemmung kann ein verschiebbares Keilelement vorgesehen sein, das mit einer Keilfläche an einer Schrägfläche der bewegbaren Klemmbacke in Anlage bringbar ist, so dass durch eine Verschiebung des Keilelements die bewegbare Klemmbacke schwenkbar und die Feder stauchbar ist. Diese Mechanik erlaubt einen automatisierten Wechsel der Thermode und ermöglicht somit eine Verkürzung der Thermodenwechselzeit bzw. der Stillstandzeit der Kontaktiervorrichtung. Die Thermoden können in einem Magazin vorgehalten werden, das zur Entnahme einer neuen Thermode entsprechend von der Kontaktiereinrichtung ansteuerbar ist.

Zur Verbesserung der Kontaktierung bzw. zur Vermeidung gefährlicher Gase beim Kontaktieren kann Schutzgas verwendet werden, welches die Thermodenspitze im Betrieb umströmt. Als Schutzgaszuführung können Schutzgaskanäle in den Klemmbacken ausgebildet sein, die im Kopfbereich der Klemmbacken, d.h. in einem axialen Abstand von etwa 1 mm von der Thermodenspitze, aus diesen austreten. Die Schutzgaszuführung kann über ein Ventil und einen Sensor zur Messung der Schutzgasparameter, insbesondere des Volumens und des Drucks, optimiert werden. Eine Absaugung des Schutzgases kann über eine becherartige Absaughaube realisiert werden, in deren Innenraum die Klemmbacken mit der Thermode eintauchen.

Eine erfindungsgemäße Zustellsystem zum Zustellen von Bearbeitungsvorrichtungen, wie zum Beispiel die erfindungsgemäße Verlege- oder Kontaktiervorrichtung, hat einen Verbindungsschlitten zur Anschluss der Bearbeitungsvorrichtung und einen Antrieb zum Verfahren des Verbindungsschlittens. Erfindungsgemäß ist der Antrieb ein Piezo-Motor, der nach dem Piezo-Leg-Prinzip funktioniert.

Eine derartiges Zustellsystem hat den Vorteil, dass es eine sehr hohe Dynamik aufweist. Weiterhin ist das Zustellsystem klein und gewichtssparend ausführbar, da zum Beispiel aufgrund der Selbsthemmung des Piezo-Motors bei Nichtbestromung ein separater Bremsmechanismus entfallen kann.

Bei einer Ausführungsform ist der Piezo-Motor mit einer Vielzahl von Fingern, ausgebildet, die bei Bestromung einen s-förmigen Weg, idealerweise eine Sinuskurve, beschreiten. Dabei wirkt zumindest ein Finger auf einen Schieber, der mit dem Verbindungsschlitten zusammenwirkt und vorzugsweise aus Keramik hergestellt ist. Die Bewegung der Finger wird auf den Schieber übertragen, wodurch dieser eine lineare Bewegung ausführt. Zur besseren Längsführung kann der Schieber mit einer den Fingern abgewandten Fläche an einer Führungsschulter anliegen und mit seinem freien Endabschnitt an einem Führungsschlitten befestigt sein, der mit dem Verbindungsschlitten für die Bearbeitungsvorrichtung verbunden ist.

Der Führungsschlitten kann mittelbar oder unmittelbar mit dem Verbindungsschlitten verbunden sein. Bei einer mittelbaren Verbindung ist vorzugsweise ein Belastungsmesser, insbesondere ein Kraftmesser, zwischen den beiden Schlitten angeordnet, über den die Verschiebung des Schiebers messbar ist, so dass regelbar in die Steuerung des Piezo-Motors eingegriffen werden kann. Zusätzlich kann der Belastungsmesser dämpfende Aufgaben übernehmen und somit Überschwingen des Piezo-Motors in gewissen Grenzen, bevorzugterweise bis zu 100 µm, ausgleichen. Auf eine bekannte Dämpfung mit einem Federelement kann daher verzichtet werden, wodurch negative Schwingungen vermieden und die hohe Dynamik des Piezo-Motors auf den Verbindungsschlitten übertragbar ist.

Eine erfindungsgemäße Verlege- und Kontaktiereinheit weist eine erfindungsgemäße Verlegevorrichtung und eine erfindungsgemäße Kontaktiervorrichtung auf. Das räumliche Zusammenfassen der Verlege- mit der Kontaktiervorrichtung hat den Vorteil, dass platzsparend zwei Verfahren durchgeführt werden können.

Bei einer bevorzugten Ausführungsform sind die Verlegevorrichtung und die Kontaktiervorrichtung in einer gemeinsamen Halterung angeordnet, die über zwei erfindungsgemäße Zustellsysteme in x- und in y-Richtung verfahrbar sind. In x-Richtung bedeutet dabei eine Zustellung in Längsrichtung eines Maschinenbettes und in y-Richtung bedeutet eine Verschiebung in der Ebene quer zur Längsrichtung des Maschinenbettes. Zur Zustellung in z-Richtung, d.h. in Vertikalrichtung, können die Vorrichtungen bevorzugterweise einzeln an jeweils einem erfindungsgemäßen Zustellsystem angeordnet sein.

Eine erfindungsgemäße Herstellungsanlage insbesondere zur Herstellung von Chipkarten, sieht eine Bestückungsstation zum Bestücken des Substrates mit einem Chip, eine Verlegestation zum Verlegen eines Drahtes auf einem Substrat, und eine Kontaktierstation zum Kontaktieren des Drahtes mit dem Chip vor. Erfindungsgemäß sind die Stationen an Konsolen angeordnet, die individuell in x-, y-und z-Richtung verfahrbar sind.

Gegenüber den bekannten Lösungen wie der eingangs erwähnten Portalbauweise hat diese Konsolenbauweise den Vorteil, dass die Zugänglichkeit und Beobachtungsmöglichkeit erhöht sind, da keine Vertikalstützen den Raum am Maschinenbett und die Sicht versperren. Vorzugsweise beträgt die Taktzeit etwa 10 s.

Bei einer bevorzugten Ausführungsform sind die Konsolen an einer Längsseite eines Maschinenbettes angeordnet und kreuzschlittenartig ausgeführt, wobei sie über bekannte Spindel- oder Linearantriebe bewegbar sind. Die einzelnen Stationen bestehen aus einer Vielzahl von bekannten Bestückungsvorrichtungen bzw. den erfindungsgemäßen Verlegevorrichtungen bzw. den erfindungsgemäßen Kontaktiervorrichtungen.

Selbstverständlich kann jedoch auch die Verlegestation mit der Kontaktierstation an einer Konsole zu einer Verlege- und Kontaktierstationseinheit zusammengefasst werden. Eine derartige Stationseinheit ist dann von einer Vielzahl der erfindungsgemäßen Verlege- und Kontaktiereinheit gebildet, wobei eine derartige Verlege- und Kontaktierstationseinheit der Bestückungsstation nachgeschaltet wäre.

Die Produktivität der Herstellungsanlage lässt sich steigern, wenn die einzelnen Vorrichtungen im Gegensatz zur bekannten Portalbauweise nicht nur nebeneinander, sondern flächig, d.h. sowohl nebeneinander als auch hintereinander, an den Konsolen positioniert sind. Beispielsweise können somit etwa 10 Vorrichtungen jeweils eine Station bilden.

Die Zustellung der einzelnen Vorrichtungen in z-Richtung kann über individuelle erfindungsgemäße Zustellsystem erfolgen.

Zum Stanzen von Chipfenstern in das Substrat, kann eine Folienstanzstation vorgesehen sein, die auf dem Maschinenbett in x-Richtung verschiebbar ist. Vorzugsweise ist die Folienstanzstation als eine höchste Genauigkeitsanforderungen erfüllende Fensterstanze ausgebildet.

Ebenso kann eine Schneidestation zur Unterteilung der mit der Transpondereinheit versehenen Substrate in handbare Verarbeitungseinheiten. Die Scheidestation ist in x-Richtung auf dem Maschinenbett verfahrbar und zur Optimierung eines Schnittbildes mit einem Ultraschallmesser ausgerüstet. Die Flexibilität der gesamten Herstellungsanlage lässt sich steigern, wenn die Schneidestation derart frei programmierbar ist, dass eine Rolle-Bogen-und/oder Rolle-Rolle-Bearbeitung ohne Umrüstung möglich ist.

Zur Verbesserung einer Haftung der verlegten Drahtwicklungen auf den Folien bzw. den Nutzen kann eine Beschichtungsstation zum Auftragen einer Beschichtung auf zumindest den Flächenbereichen der Folie bzw. des Nutzens vorgesehen sein, in die die Drahtwicklungen eingebracht werden.

Bei einer anderen bevorzugten Ausführungsform können die Transpondereinheiten aus einzelnen Bögen gefertigt werden, die manuell der Herstellungsanlage zugeführt und anschließend nach der Bearbeitung manuell wieder entnommen werden können. Diese Ausführungsform ist besonders für Kleinserien geeignet und erlaubt ein individuelle Bestückung der Transpondereinheiten. Zu diesem Zweck kann die Herstellungsanlage zumindest einen Schlitten zur Aufnahme eines zu bestückenden Bogens aufweisen, der verfahrbar auf dem Maschinenbett geführt ist und die einzelnen Konsolen anfährt. Zur Rückführung des Schlittens kann eine Rückführung vorgesehen sein, durch die der Schlitten zurück zu seiner Ausgangsposition, d. h. die Position, in der der zu bearbeitende Bogen auf den Schlitten aufgelegt worden ist, führbar ist, so dass das Entnehmen des bestückten Bogens von dem zurückgeführten Schlitten und das Auflegen eines neuen Bogens auf diesen Schlitten von einem Operator durchgeführt kann. Vorteilhafterweise ist die Rückführung im Maschinenbett angeordnet, so dass durch die Rückführung kein zusätzlicher Platz neben der Herstellungsanlage notwendig ist.

Um ein Verrutschen des Bogens auf dem Schlitten zu verhindern, kann eine mechanische oder eine magnetische Klemmeinrichtung zum Klemmen des Bogens auf dem Schlitten vorgesehen sein.

Bei einer anderen Ausführungsform ist sowohl eine mechanische als auch magnetische Klemmeinrichtung vorgesehen, die an entfernt voneinander liegenden Randbereichen des Bogens angreifen. Dabei erstrecken sich die Randbereiche vorzugsweise in Zuführrichtung des Schlittens.

Die mechanische Klemmeinrichtung kann am Schlitten lagefixiert sein und eine in Klemmstellung federvorgespannte Klemmpratze aufweisen.

Die magnetische Klemmeinrichtung kann eine beliebig auf dem Schlitten positionierbare Klemmleiste mit einem Magnetband aufweisen.

Ein erfindungsgemäßes Verfahren zur Herstellung einer Transpondereinheit sieht vor, den Draht beim Verlegen auf dem Substrat mit Ultraschallwellen zu beaufschlagen, die parallel zur Verlegeebene verlaufen. D.h. die Ultraschallwellen werden in horizontaler Richtung zur Längsachse der, den Draht zuführenden Sonotrode in den Draht eingeleitet.

An dieser Lösung ist vorteilhaft, dass der Draht in das Substrat "eingerieben" wird, wodurch sich Verschmutzungen, zum Beispiel seiner Isolierung, lösen und die Verlegequalität entsprechend verbessert wird. Weiterhin können Werkzeugkosten gesenkt werden.

Bevorzugterweise wird die horizontale Schwingungsbeaufschlagung beim Direktkontaktieren angewendet. Beim Direktkontaktieren wird der Draht mit seinen Endabschnitten direkt mit Anschlussflächen des Chips verbunden. D.h. es wird auf die üblichen Chipmodule zur Vergrößerung der Anschlussflächen verzichtet.

Ein mit dem Direktkontaktieren hergestellte erfindungsgemäße Transpondereinheit zeichnet sich aufgrund des direkten Kontaktierens und den Wegfall des Chipmoduls durch eine reduzierte Teileanzahl und verringerte Herstellungskosten aus.

Eine Ausführungsform des Direktkontaktieren sieht vor, den Chip in einem Chipfenster eines Substrates zu positionieren. Anschließend wird ein Endabschnitt des Draht unter Ultraschallbeaufschlagung in das Substrat eingebracht, wobei der Draht über eine erste Anschlussfläche des Chips geführt wird. Nach dem Überqueren des Chips wird der Draht mittels thermischer Schweißung mit der ersten Anschlussfläche des Chips verbunden. Das Verlegen des Drahtes unter Ultraschallbeaufschlagung wird fortgesetzt, bis sich die gewünschte Drahtspule auf dem Substrat ausbildet, wobei der Draht abschließend die verlegten Drahtwicklungen kreuzt und über eine zweite Anschlussfläche des Chips geführt wird. Zum Kontaktieren des Drahtes mit der zweiten Anschlussfläche wird der Draht mit dieser verschweißt.

Ein bevorzugter Frequenzbereich der Ultraschallschwingungen beträgt etwa 100 kHz.

Beim Kreuzen der verlegten Drahtwicklungen und/oder beim Überqueren der Anschlussflächen kann die Ultraschallbeaufschlagung ausgesetzt werden.

Zum Durchtrennen des Drahtes nach der Verschweißung mit der zweiten Anschlussfläche kann der Draht eine Rückzugbewegung ausführen, wodurch dieser im Bereich der Schweißung durchrissen wird. Die Rückzugbewegung kann mittels der erfindungsgemäßen Vorschubeinrichtung erleichtert werden.

Als bevorzugte Verlegevorrichtung und/oder Kontaktvorrichtung kann eine erfindungsgemäße Verlege- und Kontaktiereinheit verwendet werden.

Sonstige vorteilhafte Ausführungsformen sind Gegenstand weiterer Unteransprüche.

Im Folgenden werden bevorzugte Ausführungsformen der Erfindung anhand schematischer Darstellungen näher erläutert. Es zeigen
Figur 1 einen Ansicht einer ersten erfindungsgemäßen Verlegevorrichtung,
Figur 1a einen Ausschnitt der Sonotrode aus Figur 1 mit einer externen Kühleinrichtung,
Figur 1b eine Ansicht einer zweiten erfindungsgemäßen Verlegevorrichtung,
Figur 2 eine Ansicht einer erfindungsgemäßen Kontaktiervorrichtung,
Figur 3 ein erfindungsgemäßes Zustellsystem zur Zustellung einer Verlege- und einer Kontaktiervorrichtung,
Figur 4 eine Kombination einer zweiten erfindungsgemäßen Verlegevorrichtung mit der Kontaktiervorrichtung gemäß Figur 2,
Figur 5 eine Draufsicht auf eine erfindungsgemäße Herstellungsanlage,
Figur 6 eine Draufsicht auf eine zweite Ausführungsform einer erfindungsgemäßen Herstellungsanlage,
Figur 7 eine Seitenansicht der Herstellunganlage nach Figur 6, und
Figur 8 eine Seitenansicht eines Schlittens aus Figur 6 mit bevorzugten Klemmeinrichtungen

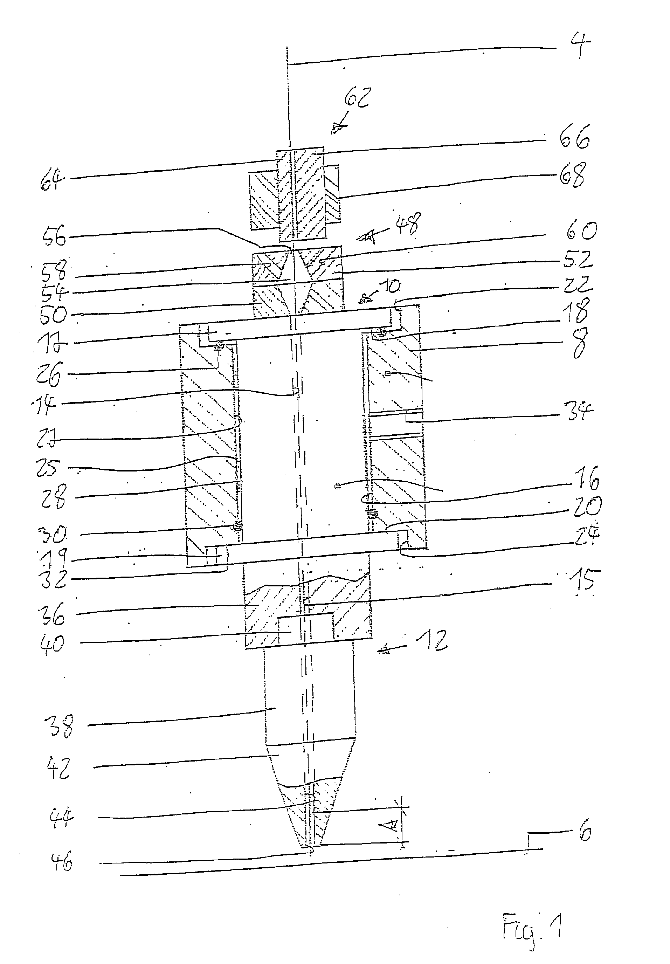

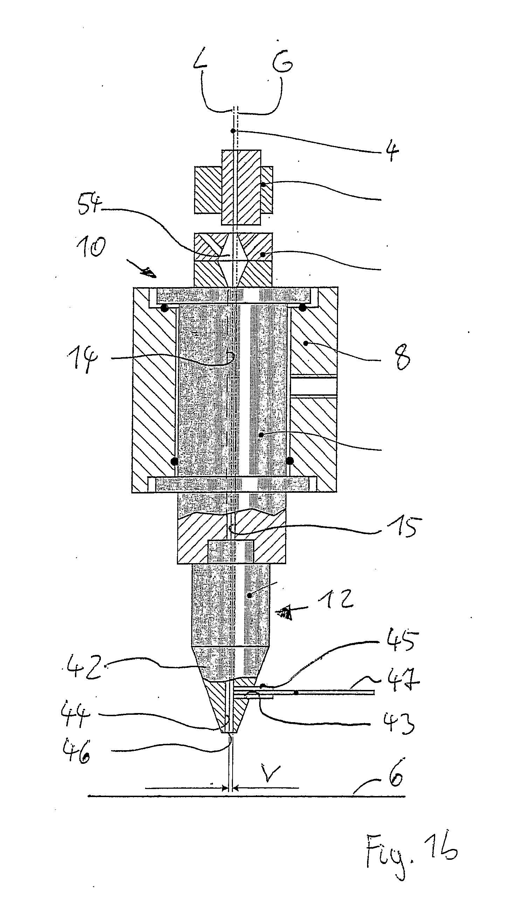

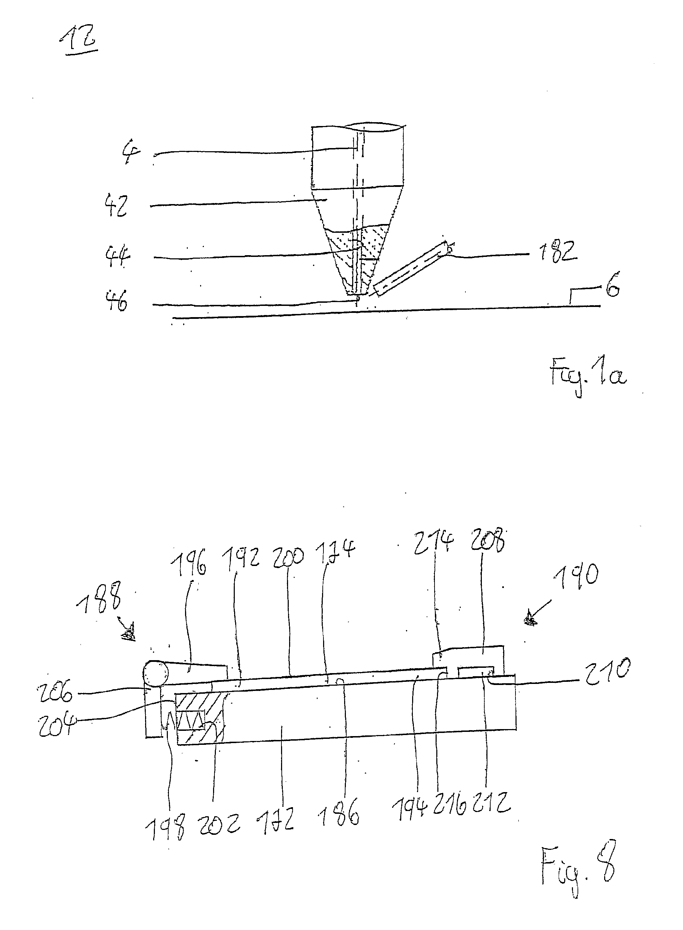

Gemäß Figur 1 hat eine Ausführungsform einer erfindungsgemäßen Verlegevorrichtung 2 zur Verlegung eines isolierten Drahtes 4 als Antenne auf einem Substrat 6 zur Herstellung einer Transpondereinheit, zum Beispiel für Chipkarten oder zur Verlegung von Antennen in Handy-Gehäusen, ein in einem rohrartigen Gehäuse 8 aufgenommenen Ultraschallkonverter 10 und eine Sonotrode 12. Erfindungsgemäß wird der Draht axial der Verlegevorrichtung 2 zugeführt. Zur Führung des Drahtes 4 ist in der Verlegevorrichtung 2, eine koaxiale Drahtführung in Form eines Durchgangskanals ausgebildet, der sich aus mehreren Einzelbohrungen 14, 15, 44, 54 zusammensetzt.

Der Ultraschallkonverter 10 dient zur Beaufschlagung der Sonotrode 12 und somit des Drahtes 4 mit Ultraschallschwingungen im Bereich von etwa bis zu 60 kHz. Er hat einen zylindrischen Körper, der von einer zur Längsachse der Sonotrode 12 koaxialen Durchgangsbohrung 14 zur Aufnahme des Drahtes 4 durchsetzt ist. Mit zwei stirnseitigen Ringschultern 17, 19 taucht er in zwei endseitige Ausnehmungen 22, 24 des Gehäuses 8 ein, wobei zwischen seiner Außenumfangswandung 25 und einer gegenüberliegenden Innenumfangswandung 27 des Gehäuses 8 ein Ringraum 16 ausgebildet ist.

Der Ringraum 16 ist durch Ringschulterflächen 16, 18 der Ringschultern 17, 19 axial begrenzt und über einen Dichtungsring 26, der in eine stirnseitigen Ringnut der Ausnehmung 20 eintaucht und an der Ringschulterfläche 18 anliegt axial, sowie über einen Dichtungsring 26, der in eine Innenumfangsnut des Gehäuses 8 eintaucht und an einem Abschnitt der Außenumfangswandung 25 des Ultraschallkonverters 10 anliegt in Umfangsrichtung abgedichtet. Mit seiner zweiten Ringschulterfläche 20 liegt er plan an einer gegenüberliegenden Bodenfläche 28 der Ausnehmung 20 an. Vorzugsweise beträgt ein radiales Spiel des Ultraschallkonverters 10 in dem Gehäuse 8 etwa 20 µm und ein axiales Spiel etwa 100µm.

Über eine Querbohrung 34 mit einem Innengewinde kann ein gasförmiges oder flüssiges Medium in den Ringraum 16 eingeleitet werden, so dass der Ultraschallkonverter 10 schwimmend gelagert ist und im Betrieb aufgrund der erzeugten Ultraschallschwingungen sowohl Drehbewegungen als auch Axialbewegungen ausführen kann. Vorzugsweise wird Pressluft mit einem Druck von etwa 6 bar in den Ringraum 14 eingeblasen.

Der Ultraschallkonverter 10 steht über ein stirnseitiges radial zurückgestufte Konverterhorn 36 mit einem zylindrischen Schaft 38 der Sonotrode 12 in Verbindung. Das Konverterhorn 36 ist vorzugsweise mit dem Ultraschallkonverter 10 verschraubt und verfügt über eine zur Längsachse der Sonotrode 12 koaxiale Axialbohrung 15. Das Konverterhorn 36 ist ebenso mit dem Schaft 38 der Sonotrode 12 verschraubt. Wie in der Figur 1 angedeutet hat es zusätzlich eine stirnseitige Zentrierausnehmung 40, in die ein Zentriervorsprung 41 der Sonotrode 12 eingreift. Die Zentrierung hat den Vorteil, dass die Axialbohrung 15 des Schafts 36 genau koaxial zur Längsachse der Sonotrode 12 positioniert ist.

Der Schaft 38 geht in einen konischen Kopfbereich 42 der Sonotrode 12 über. In der Sonotrode 12 ist koaxial zur Längsachse eine Durchgangsbohrung 44 ausgebildet, die sich von dem Zentriervorsprung 41 zu einer stirnseitigen Austrittsöffnung 46 im Kopfbereich 42 erstreckt. Zur besseren Führung des Drahtes 4 ist die Durchgangsbohrung 44 im Bereich der Austrittsöffnung 46 radial verjüngt. Bevorzugterweise hat die Durchgangsbohrung 44 auf einer axialer Länge A von etwa 2 mm bis 3 mm von der Austrittsöffnung 46 aus betrachtet einen Durchmesser von 300 µm.

An der, der Sonotrode 12 entgegengesetzten Stirnfläche des Ultraschallkonverters 10 ist eine Lagereinrichtung 48 angeordnet. Die Lagereinrichtung 48 hat zwei zylinderförmige Halbkörper 50, 52. Die Halbkörper 50, 53 sind stirnseitig so miteinander verbunden, dass jeweils eine, den Halbkörper 50, 52 axial durchsetzende konische Ausnehmung im Zusammenwirken mit der anderen Ausnehmung einen Innenraum 54 mit einem etwa rautenartigen Längsquerschnitt bildet. Dabei weist die konische Ausnehmung des in der Figur 1 gezeigten oberen Halbkörpers 50 eine Eintrittsöffnung 58 für den Draht 4 auf.

Die Drahtführung setzt sich in der Verlegevorrichtung 2 aus dem Innenraum 54, der Durchgangsbohrung 14, der Axialbohrung 15 und der Längsbohrung 44 zusammen. Folglich ist die Verlegevorrichtung 2 koaxial zur Längsachse der Sonotrode 12 von einem Durchgangskanal durchsetzt. Vorzugsweise hat der Durchgangskanal einen Durchmesser von 3 mm, der sich wie vorbeschrieben im Kopfbereich 42 der Sonotrode 12 auf etwa 300 µm reduziert. Dabei erlaubt insbesondere die stirnseitige Anordnung der Eintrittsöffnung 56 eine axiale Zuführung des Drahtes 4.

Über Radialbohrungen 58, 60 bzw. einen Bohrungsstern kann in den Innenraum 54 und somit in die Drahtführung ein gasförmiges Medium einströmen, das zur reibungsarmen Führung des Drahtes 4 dient. Vorzugsweise wird Pressluft verwendet, so dass der Draht 4 mittels aerostatischer Lagerung in der Drahtführung nahezu reibungslos geführt ist. Dabei bildet sich aufgrund des verjüngenden Bereichs in der Durchgangsbohrung 44 der Sonotorde 12 im Bereich der Austrittsöffnung 46 ein Staudruck aus, durch den die Führung verbessert ist.

Um die Taktzeit zur Verlegung zu verkürzen kann die Pressluft vorgewärmt werden. Ein bevorzugter Temperaturbereich beträgt etwa 50°C bis 60°C. Durch die Vorwärmung wird insbesondere die Isolierung des Draht 4 erwärmt, so dass die Verbindung mit dem Substrat 6 schneller erfolgen kann.

Zum Zuführen und Einfädeln des Drahtes 4 in die Eintrittsöffnung 56 ist eine Vorschubeinrichtung 62 vorgesehen. Die Vorschubeinrichtung 62 weist im wesentlichen zwei Greifer 64, 66 auf, von denen zumindest einer bewegbar an einer Halterung 68 gelagert ist, so dass ein einzufädelnder Endabschnitt des Drahtes 4 ergriffen und gezielt geführt werden kann. Die Halterung 68 ist beliebig zur Verlegevorrichtung 2 verfahrbar, wobei sie bei entsprechender Ansteuerung ebenfalls eine Rückwärtsbewegung ausführen kann. Durch ein wiederholendes Lösen, Zurückfahren, Ergreifen und Vorfahren der Vorschubeinrichtung 62 kann der Draht 4 schrittweise automatisiert zur Austrittsöffnung 46 befördert werden. Somit ist es beispielsweise möglich, den Draht 4 mit seinem freien Endabschnitt über die Verlegevorrichtung 2 in eine Öffnung eines geschlossenes Gehäuse zuführen und ihn anschließend außerhalb des Gehäuses auf diesem zu verlegen.

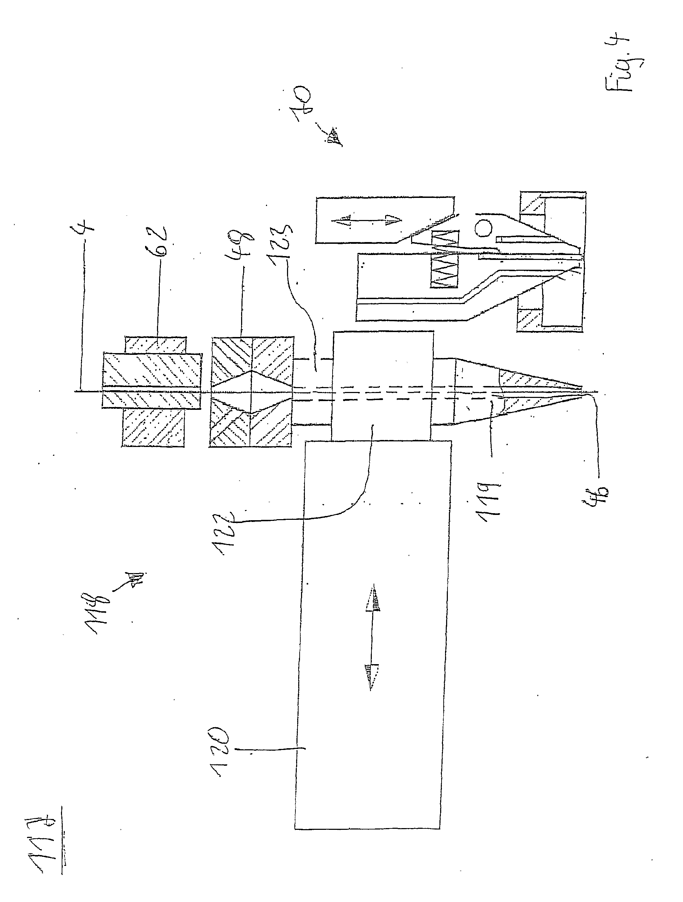

Eine Rückwärtsbewegung ist insbesondere auch dann vorteilhaft, wenn der Draht 4 nach der Verlegung und Kontaktierung zu trennen ist. In einem solchen Fall kann der Draht 4 durch eine Rückwärtsbewegung im Bereich der Kontaktierung durchrissen werden (vgl. Figur 4).

Bei einer bevorzugten Ausführungsform ist gemäß Figur 1b der Ultraschallkonverter 10 in Radialrichtung versetzt in dem Gehäuse 8 angeordnet, so dass der sich aus den Einzelbohrungen 14, 15, 44 und 54 zusammensetzende Durchgangskanal exzentrisch zur Gehäuselängsachse G verläuft und die Austrittsöffnung 46 um einen Versatz V radial versetzt zur Gehäuselängsachse G angeordnet ist. Dabei wird der Draht 4 über die Vorschubeinrichtung 62 koaxial zur Längsachse L des Durchgangskanals zugeführt, so dass dieser "mittig" in dem Durchgangskanal geführt ist. Vorzugsweise beträgt der Versatz V zwischen der Gehäuselängsachse G und der Längsachse L des Durchgangskanals etwa 0,5mm.

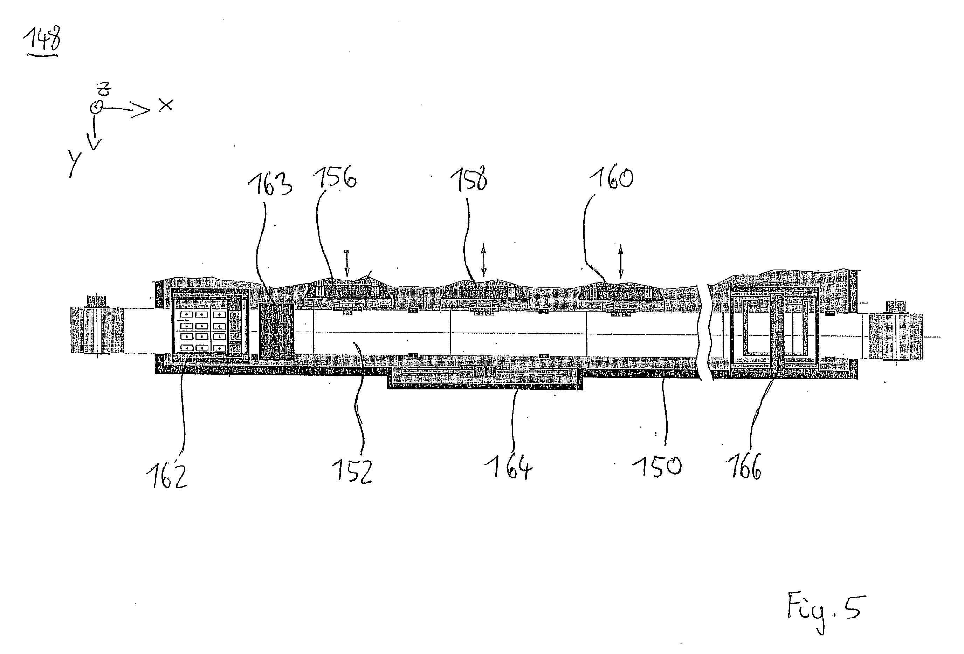

Die exzentrische Ausrichtung des Durchgangskanals zur Gehäuselängsachse G hat den Vorteil, dass durch Drehungen des Ultraschallkonverters 10 um seine Längsachse die Austrittsöffnung 46 der Sonotrode 12 relativ zum Gehäuse 8 verschiebbar ist. Dadurch ist es insbesondere möglich, bei einer Vielzahl von gleichartigen Verlegevorrichtungen 22 zur Herstellung mehrerer Transpondereinheiten gleichzeitig, die Position der Verlegevorrichtungen 22 relativ zueinander zu justieren. So ist es zum Beispiel vorstellbar, zwölf Verlegevorrichtungen 22 in einer im Nachfolgenden noch erläuterten Konsole bzw. Station (vgl. Figuren 5, 6 und 7) anzuordnen, wobei jeweils sechs Verlegevorrichtungen 22 in Vorschubrichtung (x-Richtung) hintereinander und jeweils zwei Verlegevorrichtungen 22 quer zur Vorschubrichtung (y-Richtung) angeordnet sind. Die sechs Verlegevorrichtungen 22 sind jeweils über ihr Gehäuse 4 in einer gemeinsamen sich in x-Richtung erstreckenden Nut geführt. Mit anderen Worten, die Konsole verfügt über zwei in x-Richtung verlaufende Nuten, in denen jeweils sechs Verlegevorrichtungen 22 über ihr Gehäuse 4 angeordnet sind. Zum Einstellen der Abstände zwischen den jeweils in einer der Nuten gelagerten Verlegevorrichtungen 22 in x-Richtung sind die Verlegevorrichtungen 22 frei in der Nut verschiebbar und fixierbar. Zum Justieren der Verlegevorrichtungen 22 in einer der Nuten in y-Richtung relativ zueinander werden erfindungsgemäß die Ultraschallkonverter 10 in ihrem jeweiligen Gehäuse 8 gedreht, bis aufgrund der Exzentrizität der Längsachse L des Durchgangskanals zur Gehäuselängsachse die Austrittsöffnungen 46 relativ zueinander in y-Richtung optimal angeordnet sind.

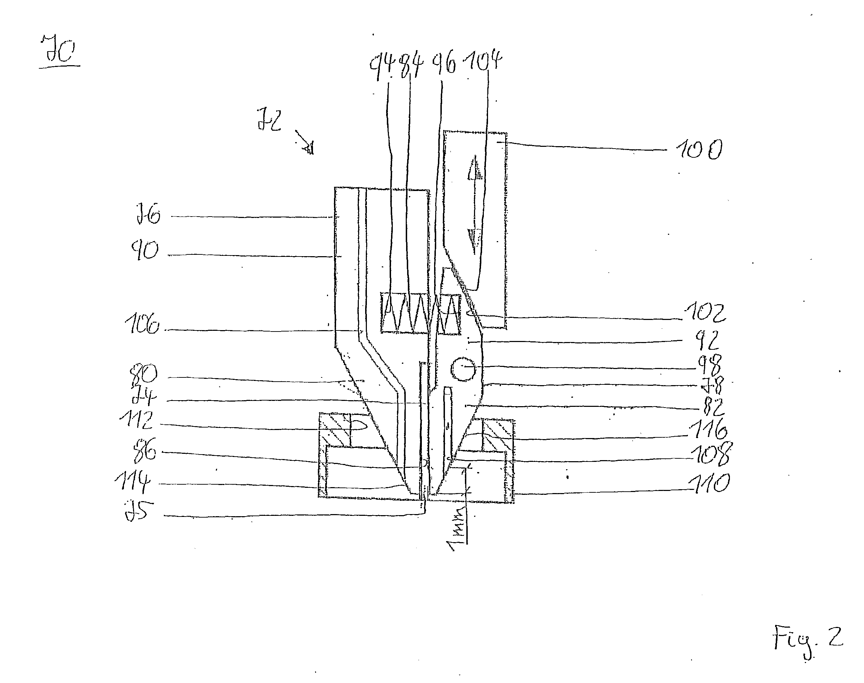

Weiterhin weist die in Figur 1b gezeigte Verlegevorrichtung im Kopfbereich 42 der Sonsotrode 12 eine Querbohrung 43 auf, die in die Längsbohrung 44 mündet und in die eine Hülse 45 eingesetzt ist, durch die ein Lichtwellenleiter bzw. eine Glasfaser 47 geführt ist, der bzw. die mit einer Energiequelle (nicht dargestellt) wie zum Beispiel einem Laser in Verbindung steht. Über die Glasfaser 47 wird das Laserlicht zum Draht 4 in der Längsbohrung 44 geführt, wodurch dieser erwärmt wird und seine Isolation definiert wegdampft, so dass der Draht 4 als blanker Kupferdraht aus der Austrittsöffnung 46 austritt und in das Substrat 6 eingebettet werden kann oder, wie im Nachfolgenden noch erläutert wird (vgl. Figuren 2, 3 und 4), mittels Thermokompressionsschweißens mit Anschlussflächen eines Chips bzw Kontaktflächen eines Chipmoduls kontaktiert werden kann ohne das durch die Isolierung eine Verunreinigung beim Verlegen bzw. Kontaktieren eingebracht werden könnte, da diese bereits entfernt wurde. Die Querbohrung 43 hat vorzugsweise einen Durchmesser von 2,6mm.

Ebenso ist es vorstellbar durch die Querbohrung 43 bzw. die Hülse 45 erwärmte Luft in die Längsbohrung 44 einzublasen, um die Isolierung des Drahtes 4 zu entfernen.

Gemäß Figur 1a kann eine Kühleinrichtung 182 zur Vermeidung einer Überhitzung des zu verlegenden Drahts 4 vorgesehen sein. Die Kühleinrichtung 182 hat eine Düse, die mit der Pressluftversorgung der aerostatischen Lagereinrichtung 48 der Verlegeeinrichtung 2 in Verbindung steht. Die Düse ist neben dem Kopfbereich 42 der Sonotrode 12 derart angeordnet, dass der aus der Längsbohrung 44 bzw. der Austrittsöffnung 46 austretende Draht 4 von der Pressluft umströmt werden kann. Die Kühlung mit Pressluft hat den Vorteil, dass diese aufgrund der Luftführung des Drahts 4 bereits bis zur Verlegeeinrichtung 2 geführt ist und somit keine aufwendige separate Zuführung erfolgen muss. Selbstverständlich sind jedoch auch andere Gase als Kühlmedium vorstellbar.

Figur 2 zeigt eine erfindungsgemäße Kontaktiervorrichtung 70 zur Kontaktierung eines Drahtes mit einem Chip mittels Temperatur- und Druckbeaufschlagung. Die Kontaktiervorrichtung 70 kann selbstverständlich auch zur Kontaktierung eines Drahtes mit einem Substrat verwendet werden. Sie hat eine Klemmanordnung 72 zur Klemmung einer Thermode 74 mit einer feststehenden und eine bewegbare Klemmbacke 76, 78, deren Kopfabschnitte 80, 82 über eine Feder 84 zur Klemmung der Thermode 74 gegeneinander vorgespannt sind.

Das Kontaktieren erfolgt durch Bestromung der Klemmanordnung 72, wobei im Bereich der Thermodenspitze 75 der größte Widerstand existiert, so dass diese erwärmt und beim Niederdrücken der Thermodenspitze 75 auf den Draht dieser erwärmt, verformt und mit dem Chip verbunden wird.

Zur Aufnahme der Thermode 74 hat der Kopfabschnitt 80 der feststehenden Klemmbacke 76 eine entsprechend der Thermode 74 geformte axiale Vertiefung 86. Der Kopfabschnitt 82 der bewegbaren Klemmbacke 78 hat einen entsprechend geformten, jedoch axial verkürzten Vorsprung 88. Bei richtiger Justierung ragt die Thermode 74 mit ihrer Thermodenspitze 75 axial über die Vertiefung 86 und den Vorsprung 88 hinaus.

Zur Aufnahme der Feder 84 ist in den sich den Kopfabschnitten 80, 82 anschließenden Backenabschnitten 90, 92 der Klemmbacken 76, 78 jeweils ein Sackloch 94, 96 ausgebildet, an dessen Grundflächen sich die Feder 84 abstützt.

Der Kopfabschnitt 82 der bewegbaren Klemmbacke 78 ist um eine Schwenkachse 98 schwenkbar, so dass die Thermode 74 selbsttätig zwischen den Klemmbacken 76, 78 eingeklemmt ist. Zum Lösen der Klemmung ist ein Keilelement 100 vorgesehen, das in Längsrichtung der Thermode 74 verschiebbar ist. Es hat eine Keilfläche 102, mit der es in Anlage mit einer entsprechend geformten Schrägfläche 104 des Backenabschnitts 90 der bewegbaren Klemmbacke 78 bringbar ist.

Bei einer Verschiebung des Keilelements 100 in Richtung der Schwenkachse 98 läuft die Keilfläche 102 auf die Schrägfläche 104 auf, wodurch die bewegbare Klemmbacke 78 gemäß Figur 2 gegen den Uhrzeigersinn um die Schwenkachse 98 verschwenkt wird. Folglich wird die Klemmung der Thermode 74 gelöst und die Feder 84 gestaucht. Zur erneuten Klemmung wird das Keilelement 100 zurückverfahren, bis die Anlage zwischen der Keilfläche 102 und der Schrägfläche 104 aufgehoben ist, wodurch sich die Feder 84 entspannt und die Thermode 74 eingeklemmt wird. Aufgrund der selbsttätigen Klemmung der Thermode 74 ist somit ein Thermodenwechsel automatisierbar. Der automatisierte Thermodenwechsel lässt sich besonders einfach ausführen, wenn die Thermoden 74 in einem Magazin vorgehalten werden, das von der Kontaktiervorrichtung 70 ansteuerbar ist.

In den Klemmbacken 76, 78 ist zumindest jeweils ein Gaskanal 106, 108 zur Zuführung von Schutzgas ausgebildet. Zur Absaugung des Schutzgases ist eine becherartige Absaughaube 110 vorgesehen. Die Absaughaube 110 hat eine koaxiale Öffnung 112 ihrer Bodenplatte, durch die die Klemmbacken 76, 78 mit ihren Kopfabschnitten in den Innenraum der Absaughaube 112 eintauchen können. Die Abgashaube 110 hat den Vorteil, dass die bei der Kontaktierung entstehenden giftigen Gase, wie zum Beispiel Salzsäure, abgesaugt werden. Die Gaskanäle 106, 108 erstrecken sich zumindest abschnittsweise in Längsrichtung der Kontaktiervorrichtung 70 und treten konzentrisch zur Thermode 74 nahe der Thermodenspitze 75 aus. Dabei ist die Schutzgaswirkung grundsätzlich um so besser ist, je näher das Gas in axialer Richtung an der Thermodenspitze 75 entlang strömen kann. Vorteilhafterweise haben die Kopfabschnitte 80, 82 angefaste Außenflächen 114, 116, wobei die Gaskanäle 106, 108 etwa in einem axialen Abstand von 1 mm von der Thermodenspitze 75 entfernt austreten.

Zur Regelung des Schutzgasmenge, insbesondere zur Ermöglichung eines oxidationsfreien Schweißens, ist ein nicht dargestelltes Ventil, vorzugsweise ein Proportionalventil, vorgesehen, dass mit einem Sensor zur Erfassung der Schutzgasparameter, wie zum Beispiel Druck oder Durchfluss, zusammenwirkt, und dessen Öffnungsquerschnitt entsprechend den erfassten Parametern verstellbar ist.

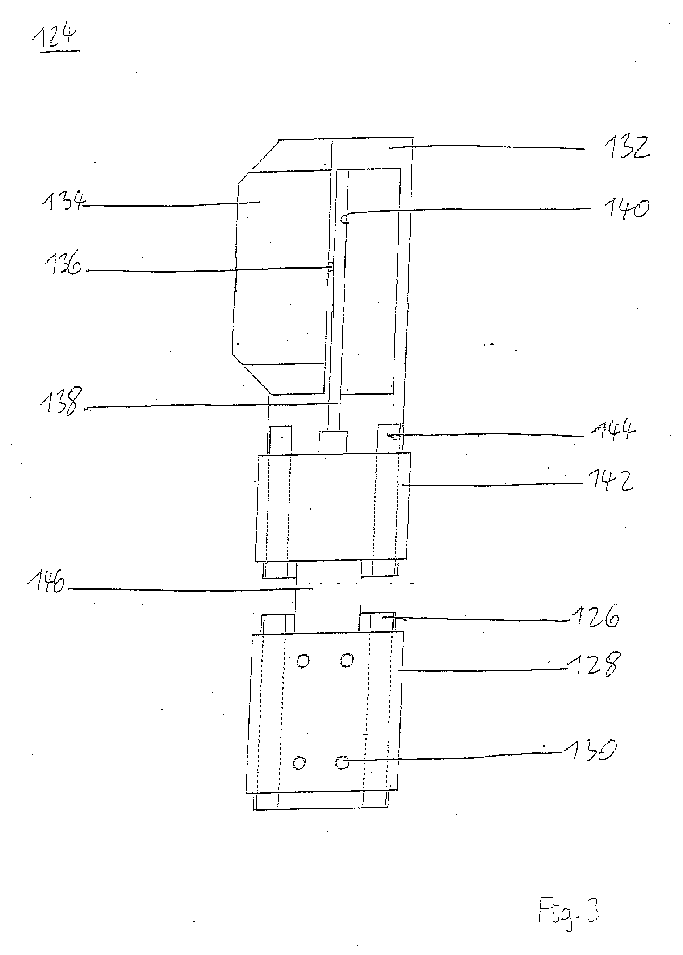

Figur 3 zeigt ein Zustellsystem 124 zur Zustellung einer Bearbeitungsvorrichtung, beispielsweise einer Verlegevorrichtung 2 nach Figur 1 oder einer Kontaktiervorrichtung 70 nach Figur 2. Ein derartiges Zustellsystem 124 erlaubt eine lineare Bewegung der Bearbeitungsvorrichtung in eine x-, y-, oder z-Richtung. Nach dem diesseitigen Verständnis entspricht die x-Richtung der horizontale Transportrichtung in Längsrichtung eines Maschinenbettes, die y-Richtung ist die horizontale Richtung quer zum Maschinenbett, d.h. quer zur x-Richtung, und die z-Richtung entspricht der Vertikalen zum Maschinenbett, d.h. in z-Richtung erfolgt eine Höhenverstellung. Bei Anordnung von drei Zustellsystemen 124 ist die Bearbeitungvorrichtung somit in sämtliche Richtungen individuell verschiebbar.

Das Zustellsystem 124 hat einen auf einer Längsführung 126 geführten Verbindungsschlitten 128 zum Anschluss und zur Verschiebung der Bearbeitungsvorrichtung. Dabei erfolgt der Anschluss der Bearbeitungsvorrichtung über ein entsprechendes Lochmuster 130 auf dem Verbindungsschlitten 128. Des Weiteren hat das Zustellsystem 124 einen Antrieb 134 zum Antreiben des Verbindungsschlittens 128, der auf einer von der Längsführung 126 getrennt ausgebildeten Grundplatte 132 angeordnet ist.

Der Antrieb 134 ist als ein Piezo-Motor, d.h. ein Piezo-Leg-Motor, ausgeführt, durch den der Verbindungsschlitten 128 in Längsrichtung verschiebbar ist. Der Antrieb 134 hat eine Vielzahl von Fingern 136 bzw. Beinen, den sogenannten Piezo-Legs, die bei Bestromung des Antriebs 134 einen s-förmigen, idealerweise einen sinusförmigen, Weg beschreiten. Dabei wirkt jeweils ein Finger 136 auf eine Vorderseite eines Schiebers 138, der somit linear verschoben wird.

Der Schieber 138 ist bevorzugterweise aus Keramik hergestellt. Um eine Verformung des Schiebers 138 bei Druckbeaufschlagung mit einem der Finger 136 zu verhindern liegt er im Bereich des Antriebs 134 mit seiner Rückseite an einer Führungsschulter 140 an. Mit einem freien, vom Antrieb 134 entfernt liegenden Endabschnitt ist er an einem Führungsschlitten 142 befestigt, der in einer Längsführung 144 läuft.

Der Führungsschlitten 142 ist mit dem Verbindungsschlitten verbunden, so dass die vom Schieber 138 auf den Führungsschlitten 142 übertragenen Längsverschiebungen an den Verbindungsschlitten 138 und somit an die Bearbeitungsvorrichtung weitergeleitet werden. Vorzugsweise sind die Schlitten 138, 142 über einen Belastungsmesser 146 miteinander verbunden.

Der Belastungsmesser 146 ist vorzugsweise als Kraftmesser ausgebildet und dient zur Messung der Verschiebeparameter, wie zB Verschiebekraft. Er ist vorzugsweise bei Zustellsystemen 124 in z-Richtung vorgesehen und derart ausgebildet, dass er ebenfalls dämpfende Eigenschaften aufweist. Vorstellbar sind zum Beispiel bekannte DMS-Sensoren. Diese Sensoren weisen meist eine E-förmige Geometrie auf, wobei an dem mittleren Balken des E's ein Drucksensor zur Messung des vom Antrieb 134 entwickelten und vom Schieber 138 übertragenen Drucks angeordnet ist. Die beiden äußeren Balken des E's erlauben eine Verformung und somit eine Dämpfung, vorzugsweise im Wegebereich von etwa 100 µm, so dass gewisse Kraftüberschwinger ausgleichbar sind.

Somit kann auf zusätzliche Dämpfungselemente wie Druckfedern zwischen den Schlitten 138, 146 verzichtet werden. Der Wegfall derartiger Dämpfungselemente hat den Vorteil, dass keine störenden Schwingungen in die Bearbeitungsvorrichtung eingeleitet werden und die hohe Dynamik des Piezo-Motors 134 quasi ungefiltert auf den Verbindungsschlitten 128 übertragbar ist. Folglich kann schnell und unmittelbar korrigierend in einen Verlege- und/oder Kontaktierprozess eingegriffen werden, so dass besonders enge Fertigungstoleranzen eingehalten werden können.

Figur 4 zeigt eine Verlege- und Kontaktiereinheit 117 mit einer Verlegevorrichtung 119 und einer Kontaktiervorrichtung 70 zur Herstellung einer Transpondereinheit mittels Direktkontaktieren. Beim Direktkontaktieren wird ein Draht 4 direkt mit Anschlussflächen eines Chip kontaktiert, was besonders hohe Genauigkeitsgrade erfordert. D.h. es wird auf die üblichen Chipmodule zur Vergrößerung der Anschlussflächen des Chips verzichtet. Selbstverständlich ist jedoch auch eine Kombination der Kontaktiervorrichtung 70 mit der unter Figur 1 beschriebenen Verlegevorrichtung 2 vorstellbar.

Grundsätzlich ist die Verlegevorrichtung 118 gemäß der Figur 4 wie die vorbeschriebene Verlegevorrichtung 2 gemäß der Figur 1 mit einer axialen Zuführung eines Drahtes 4 und einer koaxialen Drahtführung, einer sich konisch verjüngenden Sonotrode 119, einer aerostatischen Lagereinrichtung 48 und einer greifartigen Vorschubeinrichtung 62 zum Zuführen und Einfädeln des Drahtes 4 in den Durchgangskanal versehen.

Der wesentliche Unterschied zur Verlegevorrichtung 2 nach der Figur 1 besteht darin, dass ein Ultraschallkonverter 120 nicht koaxial, sondern seitlich an der Sonotrode 119 befestigt ist. Der Ultraschallkonverter 120 ist quasi seitlich zur Längsachse der Sonotrode 119 versetzt, so dass Ultraschallschwingungen horizontal, d.h. in Querrichtung zu ihrer Längsachse und somit parallel zur Verlegeebene des Drahtes 4, in die Sonotrode 119 eingebracht werden und der Draht 4 somit durch Beaufschlagung von Horizontalschwingungen in das Substrat "eingerieben" wird.

Am Schaft 123 der Sonotrode 119 ist stirnseitig die Lagereinrichtung 48 befestigt, so dass sich folglich die axiale Drahtführung nicht durch den Ultraschallkonverter 120 erstreckt.

Die seitliche Ultraschalleinrichtung 120 hat ein an einer Schmalseite angeschraubtes Konverterhorn 122, mit dem er den verlängerten Schaft 123 der Sonotrode 119 klemmend umgreift. Die Klemmung ist zum Beispiel dadurch herstellbar, dass das Konverterhorn 120 als ein axial geschlitzter Ring ausgebildet ist, der mittels Spannschrauben kraftschlüssig an dem Schaft 123 anordbar ist.

Der Ultraschallkonverter 120 ist schwimmend, zum Beispiel mittels vorbeschriebener Luftlagerung, in einer nicht dargestellten Halteelement aufgenommen, mittels dem die gesamte Verlegevorrichtung 117 getragen wird. Somit können der Ultraschallkonverter 120 und die Sonotrode 112 im Betrieb freie Bewegungen ausführen. Durch die seitliche Anordnung des Ultraschallkonverters 120 können dieser und die Sonotrode 119 noch kleiner und gewichtsreduzierter ausgeführt werden, wodurch noch höhere Ultraschallfrequenzen, beispielsweise jenseits von 100 kHz, ermöglicht werden. In einem solchen Fall weist die Sonotrode 119 im Bereich der Austrittsöffnung 46 des Durchgangskanals eine maximale Amplitude in Querrichtung von etwa 10 µm auf. Somit können neue Bearbeitungsverfahren wie zum Beispiel das erfindungsgemäße Direktkontaktierverfahren und entsprechende Transpondereinheiten realisiert werden.

Die Verlegevorrichtung 118 und die Kontaktiervorrichtung 70 sind in einer nicht dargestellten Halterung angeordnet, die in einem zentralen Achsensystem positioniert ist. Die Halterung ist in x-Richtung und y-Richtung zustellbar. In z-Richtung sind die Vorrichtungen 70, 118 individuell zustellbar. Bevorzugterweise wird jeweils als Zustellsystem ein erfindungsgemäßes Zustellsystem gemäß Figur 3 eingesetzt, so dass absolut genaue und hochdynamische Kraftfahrten ermöglicht sind.

Bei einem erfindungsgemäßen Verfahren zur Bildung einer Transpondereinheit mittels Direktkontaktierung, d.h. zur Verbindung der Endabschnitte direkt mit den Anschlussflächen eines Chips ohne die Verwendung eines Chipmoduls, wird ein Chip in einem ausgestanzten Chipfenster eines Substrats positioniert. Um eine relative Lageveränderung des Chips in dem Chipfenster zu verhindern, kann dieser mit einem Klebemittel in dem Chipfenster gesichert werden. Anschließend wird mittels der Vorschubeinrichtung 62 ein Draht 4 axial in die Lagereinrichtung 62 eingefädelt und somit der Sonotrode 12 zugeführt. Zum Verlegen des Drahtes 4 wird erwärmte Pressluft in die Luftlagereinrichtung 48 eingeblasen und der Ultraschallkonverter 120 angesteuert, vorzugsweise mit etwa 100 kHz, so dass die Sonotrode 119 mit horizontalen Ultraschallschwingungen beaufschlagt und der Draht 4 in das Substrat "eingerieben" wird. Der freie Endabschnitt des Drahtes 4 wird fixiert und der Draht über eine erste Anschlussfläche des Chips geführt. Nach der Überquerung der ersten Anschlussfläche wird die Kontaktiervorrichtung 70 angesteuert und der Draht 4 mit der Anschlussfläche verschweißt. Das Verlegen des Drahtes 4 unter Ultraschallbeaufschlagung wird fortgesetzt, bis die gewünschte Anzahl an Drahtwicklungen bzw. die Drahtspule verlegt ist. Abschließend wird der Draht 4 über die verlegten Wicklungen und über eine zweite Anschlussfläche des Chips geführt. Dabei kann sich aufgrund der Isolierung des Drahtes 4 beim Kreuzen der bereits verlegten Wicklungen kein Kurzschluss ergeben. Zum Kontaktieren des Drahtes 4 mit der zweiten Anschlussfläche wird wieder die Kontaktiervorrichtung 70 angesteuert. Durch das Niederdrücken des Drahtes 4 beim Verschweißen mit der Thermodenspitze 75 wird der Draht erwärmt, verformt und somit mit der zweiten Anschlussfläche verschweißt. Zum Zertrennen des Drahtes nach erfolgreicher Verlegung und Schweißung wird die Thermodenspitze 75 auf dem Draht 4 niedergedrückt zu gehalten. Anschließend ergreift die Vorschubeinrichtung 62 den Draht 4 und führt eine Rückwärtsbewegung aus, so dass der Draht 4 auf Zug belastet und im Bereich der Deformation durch die Thermodenspitze 75, d.h. im Bereich der Schweißung, zerrissen wird. Somit ist die Transpondereinheit fertig gestellt und kann der Verlege- und Kontaktiereinheit 117 entnommen werden.

Wahlweise kann beim Kreuzen der verlegten Drahtwicklungen bzw. beim Überqueren der Anschlussflächen die Ultraschallbeaufschlagung des Drahtes 4 ausgesetzt werden.

Während des gesamten Verfahrens werden die einzelnen Verlege- und Kontaktierschritte über eine optische Überwachungseinrichtung kontrolliert. Bei unzulässigen Ist-Abweichungen von den Soll-Abweichungen werden die Zustellsysteme entsprechen angesteuert, so dass durch eine sofortige Nachregelung die unzulässigen Ist-Abweichungen korrigiert bzw. von Anfang an verhindert werden.

Figur 5 zeigt eine erfindungsgemäße Herstellungsanlage 148 zur Herstellung einer Vielzahl von Transpondereinheiten.

Die Herstellungsanlage 148 weist ein Maschinenbett 150 zum Transport eines Nutzens 152 auf. Der Nutzen 152 wird durch Greifeinrichtungen 154 taktweise, zum Beispiel im 10 s Takt zu einzelnen, an Konsolen 156, 158 ,160 angeordneten Bearbeitungsstationen bewegt. Beispielhaft sind in der Figur 5 nur drei Konsolen 156, 158, 160 dargestellt.

Die Konsolen 156, 158, 160 sind an einer Längsseite des Maschinenbettes 150 angeordnet. Somit hat ein Operator von der entgegengesetzten Längsseite des Maschinenbettes 150 aus freie Sicht auf und freie Zugänglichkeit zu den Bearbeitungsstationen. Die Konsolen 156, 158, 160 sind kreuzschlittenartig ausgebildet, wodurch sie in x-Richtung und in y-Richtung einzeln verfahrbar sind. Dabei sind sie in y-Richtung derart zustellbar, dass die gesamte Breite des Nutzens 152 überfahrbar ist. Die Zustellung kann zum Beispiel über Spindelantriebe erfolgen, die mit entsprechenden in Längsführung gelagerten Kreuzschlitten in Verbindung stehen.

Vorstellbare Bearbeitungsstationen sind beispielsweise eine Heftstation zum Heften einer Trägerbahn mit einer Folie, in der Chipfenster eingebracht sind, zum Nutzen, eine Bestückungsstation zum Bestücken des Nutzens mit Chips, eine Verlegestation zum Verlegen von Drähten auf dem Nutzen und eine Kontaktierstation zum Kontaktieren der Drähte mit den Chips. Dabei setzen sich die einzelnen Bearbeitungsstationen aus einer Vielzahl von Heftvorrichtungen, Bestückungsvorrichtungen, Verlegevorrichtungen 2 gemäß Figur 1 und Kontaktiervorrichtungen 70 gemäß Figur 2 zusammen.

Die einzelnen Vorrichtungen sind jeweils flächig nebeneinander und hintereinander, d.h. in x- und in y-Richtung, an den Konsolen 156, 158, 160 angeordnet, wodurch eine hohe Produktivität erzielbar ist. So ist es beispielsweise möglich, 10 Vorrichtungen an jeweils einer Konsole 156, 158, 160 anzuordnen.

Eine Zustellung der Vorrichtungen in z-Richtung erfolgt individuell über jeweils ein einzeln zugeordnetes Zustellsystem nach Figur 3.

Auf dem Maschinenbett 150 ist eingangs eine Folienstanzstation 160 zum Stanzen von Chipfenstern angeordnet. Sie ist vorzugsweise eine in x-Richtung verschiebbare Fensterstanze, wodurch Verzerrungen verhindert und sehr hohe Genauigkeiten erzielbar sind.

Gegenüber der Konsole 158 zur Aufnahme der Bestückungsstation ist an dem Maschinenbett 150 eine herkömmliche Modulstanzstation 164 zum Stanzen der Chips mit den Chipmodulen aus einer angelieferten Transporteinheit angeordnet.

Ferner ist auf dem Maschinenbett 150 eine Schneidestation 166 zum Schneiden des Nutzens 152 in handbare Verarbeitungseinheiten zur vereinfachten weiteren Verarbeitung, wie zum Beispiel dem Laminieren, angeordnet. Die Schneidestation 166 weist ein Ultraschallmesser auf und ist frei programmierbar, d.h., ohne eine Umrüstung kann die Schneidestation 166 Rolle-Bogen- oder Rolle-Rolle-Bearbeitung durchführen.

Zur Herstellung einer Transpondereinheit wird eine Folie durch die Folienstanzstation 162 geführt, in der die Chipfenster zur Aufnahme der Chips mit den Chipmodulen ausgestanzt werden. Nach dem Stanzen wird die Folie der Heftkonsole 156 zugeführt. Gleichzeitig wird eine Trägerbahn unter der Folienstanzstation 162 zur Heftkonsole 156 geführt. Bei der Heftkonsole 156 wird die Folie und die Trägerbahn zu einem Nutzen 150 zusammengeheftet und weiter an die Bestückungskonsole 158 gefördert. Bei der Bestückungskonsole 158 werden die durch die Modulstanzstation 164 ausgestanzten Chips mit den Chipmodulen in die Chipfenster eingesetzt. Anschließend werden die Drahtwicklungen bei der Verlegekonsole 160 auf dem Nutzen 152 verlegt und bei der nicht dargestellten Kontaktierkonsole mit den Chips verbunden. Abschließend wird eine Schutzfolie zugeführt und mit dem Nutzen 152 geheftet. In der Schneidestation 166 werden dann der Nutzen 152 in eine Vielzahl von handbare Verarbeitungseinheiten geschnitten und dem Maschinenbett 148 beispielsweise zum Laminieren, entnommen.

Bei dem unter Figur 4 beschriebenen Direktkontaktierverfahren kann durch den Einsatz der Verlege- und Kontaktiereinheit nach der Figur 4 die Verlegekonsole 160 und die Kontaktierkonsole zu einer einzigen Konsole zusammengefasst werden, so dass die vier Konsolen entsprechend um den Faktor 1 auf drei Konsolen reduziert sind. Ferner sei darauf hingewiesen, dass dann die Modulstanzstation 164 nicht die Chips mit den Chipmodulen ausstanzt, sondern lediglich die Chips, da auf die Chipmodule wie unter Figur 4 beschrieben verzichtet werden kann. Entsprechend bedarf es einer Anpassung der Folienstanzstation 162, um die auszustanzende Fläche der Chipfenster zu reduzieren.

Je nach dem Material der Folie kann es zur Verbesserung einer Haftung der Drahtwicklungen auf der Folie vorteilhaft sein, die Folie vor dem Verlegen des Drahtes mit einer Beschichtung zu versehen. Die Beschichtung ermöglicht die Verwendung von Materialien zur Verlegung von Drahtwicklungen, die aufgrund ihrer schlechten Verlegeeigenschaften nur bedingt geeignet sind. Ein beispielhaftes Material ist Teslin®, das für seine sehr gute Witterungs-, Temperatur- und Feuchtigkeitsbeständigkeit bekannt ist, jedoch nur eine mangelhafte Haftung der Drahtwicklungen ermöglicht. Beim Auftragen einer entsprechenden Beschichtung ist die Haftung jedoch derart verbesserbar, dass auch Folien aus diesem Material sehr gute Drahtverlegungen erlauben.

Das Auftragen der Beschichtung kann vollflächig oder in bestimmten Bereichen, wie zum Beispiel den Drahteinbringbereichen, der Folie erfolgen. Eine beispielhafte Beschichtungsdicke beträgt etwa 30µm. Das Beschichtungsmaterial härtet vorzugsweise unter ultravioletten Licht aus. Ein beispielhaftes Beschichtungsmaterial ist Polyethylen. Das Auftragen der Beschichtung erfolgt in einer Beschichtungsstation 163 mittels zum Beispiel einer Sprüh-, Streich-, Rakel-, Siebdruck, Tampondruck oder Dosiertechnik gemäß der Darstellung in Figur 5 nach der Fensterstanzstation 162 und vor der Heftstation 156. Es ist jedoch in Abhängigkeit von der gewählten Beschichtungstechnik auch vorstellbar, die Beschichtungsstation 163 zwischen der Heftskonsole 156 und der Bestückungskonsole 158 anzuordnen.

Zum Aushärten der Beschichtung ist es vorteilhaft, wenn der zusammengeheftete Nutzen 150 vor der Bestückungskonsole 158 eine Pufferzone, bspw. in Form eines u-förmigen Bogens durchläuft, bevor er der Bestückungskonsole 158 zugeführt wird.

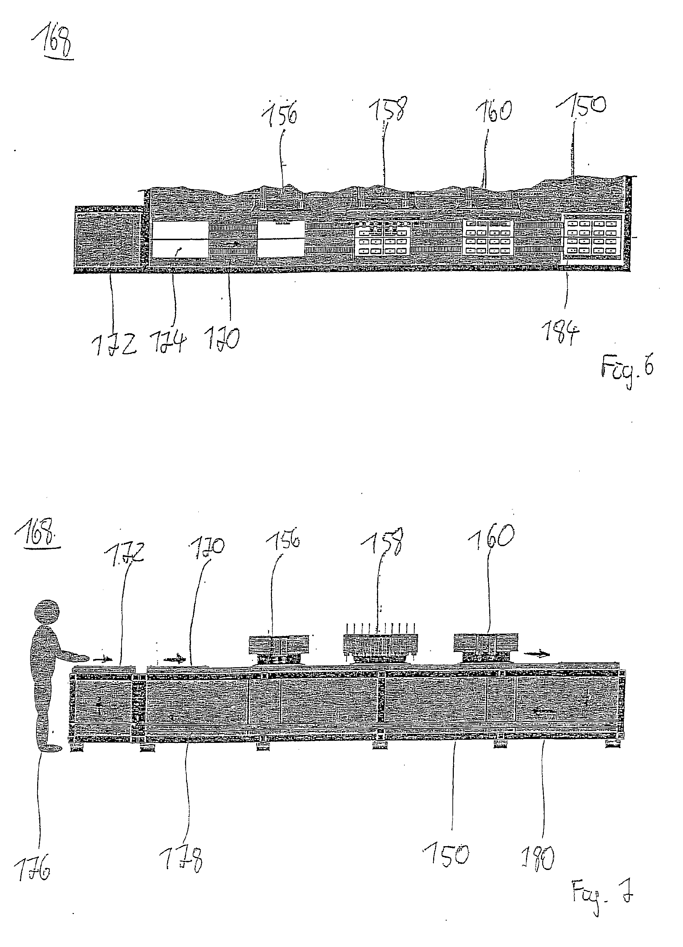

Die Figuren 6 und 7 zeigen eine zweite Ausführungsform einer erfindungsgemäßen Herstellungsanlage 168. Wie bei der vorbeschriebenen Herstellungsanlage 148 nach der Figur 5 sind einseitig an einem Maschinenbett 150 Konsolen 156, 158, 160 zur Aufnahme von der erfindungsgemäßen Bearbeitungsstationen angeordnet. Die Konsolen 156, 158, 160 weisen den gleichen Aufbau und die gleichen Bewegungsmöglichkeiten in x-, y- und z-Richtung wie die der Herstellungsanlage 148 nach Figur 5 auf, so dass diesbezüglich keine wiederholenden Erklärungen erfolgen, sondern auf die vorstehenden Erläuterungen verwiesen wird.

Ein wesentliches Merkmal dieser Herstellungsanlage 168 besteht darin, dass eine Vielzahl von Transpondereinheiten 184 aus einzelnen Bögen 174 gefertigt werden, die manuell auf Schlitten 172 gelegt werden und die einzelnen Konsolen 156, 158, 160 durchlaufen, wobei die Bögen 174 nach der Bearbeitung zurück zur Ausgangsposition geführt und dort manuell von den Schlitten 172 entnommen werden. D.h. die Bögen 174 werden im Kreis geführt, wobei das Auflegen auf den jeweiligen Schlitten 172 bzw. dessen Auflagefläche 186 und die Entnahme von dem jeweiligen Schlitten 172 manuell über einen Operator 176 erfolgt. Zur Verdeutlichung dieser kreisartigen Bewegung der Bögen 174 sind in der Figur 7 Pfeile eingezeichnet. Aufgrund der manuellen Handhabung der Bögen 174 ist diese Herstellungsanlage 168 besonders für individuelle Kleinserien geeignet. Gemäß dem rechten Bogen 172 in Figur 6 können zum Beispiel aus einem Bogen 172 sechszehn Tranpondereinheiten 184 gefertigt werden.

Die Schlitten 172 zur Aufnahme der zu bestückenden Bögen 174 sind auf dem Maschinenbett 150 über eine Zuführung 170 verfahrbar gelagert. Bei der vorliegenden Ausführungsform sind die Bögen 174 derart vorbereitet, dass sie bereits Fenster zur Aufnahme eines jeweiligen Chips aufweisen. Die Bögen 174 werden an der Ausgangsposition von dem Operator 176 manuell auf den jeweiligen Schlitten 172 gelegt und über den Schlitten 172 nacheinander zu den einzelnen Konsolen 156, 158, 160 gefahren. Gemäß der Darstellung in den Figuren 6 und 7 bewegen sich dabei die Schlitten 172 von links nach rechts. Beispielsweise können an der ersten Konsole 156 die Chips für die Transpondereinheiten 184 in die Fenster gelegt, an der zweiten Konsole 158 die Drähte 4 auf den Tranpondereinheiten 184 verlegt und an der dritten Konsole 160 die Drähte 4 mit ihren Enden mit dem jeweiligen Chip verbunden werden. Das Auftragen einer Schutzfolie kann manuell nach der Rückführung der Bögen 174 zur Ausgangsposition und nach der Entnahme der Bögen 174 durch den Operator 176 erfolgen.

Zur Rückführung der bestückten Bögen 174 zum Operator 176, d. h. zur Bewegung der Schlitten 172 gemäß den Darstellungen in den Figuren 6 und 7 von rechts nach links, ist eine Rückführung 178 vorgesehen, die vorzugsweise in einem Innenraum 180 des Maschinenbetts 150 gemäß der Figur 7 unterhalb der Zuführung 170 verläuft. Die Rückführung 178 steht mit der Zuführung 170 über jeweils eine nicht dargestellte Hubeinrichtung endseitig zum Absenken und zum Anheben der Schlitten 172 in Verbindung. Beim Absenken eines Schlittens 172 wird dieser, nachdem er die Konsolen 156, 158, 160 durchlaufen hat, mit dem bestückten Bögen 172 von dem gemäß der Figur 7 rechten Endbereich der Zuführung 170 an die Rückführung 178 übergeben. Beim Anheben wird dieser Schlitten 172 von dem gemäß der Figur 7 linken Endbereich der Rückführung 178 zurück zu seiner Ausgangsposition beim Operator 176 bewegt, so dass der Operator 176 den bestückten Bogen 174 von dem angehobenen Schlitten 172 entnehmen und auf diesen dann freien Schlitten 172 einen neuen zu bearbeitenden Bogen 174 legen kann, der anschließend über die Zuführung 170 den einzelnen Konsolen 156, 158, 160 zuführbar ist.

Um ein Verrutschen des Bogens 174 auf der Auflagefläche des Schlittens 172 zu verhindern, kann gemäß Figur 8 eine mechanische Klemmeinrichtung 188 und eine magnetische Klemmeinrichtung 190 vorgesehen sein, mittels derer der Bogen 174 an entfernt voneinander liegenden und sich in Zuführrichtung erstreckenden Randbereichen 192, 194 lösbar auf der Auflagefläche 186 des Schlittens 172 klemmbar ist.

Die mechanische Klemmeinrichtung 188 weist eine am Schlitten 172 drehbar gelagerter Klemmpratze 196 auf, die über eine Vorspannfeder 198 in Klemmstellung gegen die Oberfläche 200 des Bogens 174 vorgespannt ist. Die Vorspannfeder 198 ist abschnittsweise in einer Ausnehmung 202 an einer Schmalseite 204 des Schlittens 172 aufgenommen, wobei sie an einem mit der Klemmpratze 196 verbundenen Drehschenkel 206 angreift.

Zum Auflegen eines Bogens 174 auf bzw. zur Entnahme eines Bogens von dem Schlitten 172 kann von dem Operator 176 ein nicht dargestellter Öffnungsmechanismus, vorzugsweise ein Pneumatikzylinder, derart angesteuert werden, dass gemäß der Ansicht nach Fig. 8 die Klemmpratze 196 gegen die Vorspannkraft der Vorspannfeder 198 eine Drehung entgegen dem Uhrzeigersinn ausführt, so dass die Klemmpratze 196 von der Auflagefläche 186 des Schlittens bzw. von der Oberfläche 200 des Bogens 174 beabstandet ist. Der Öffnungsmechanismus kann selbstverständlich auch auf andere Art und Weise wie zum Beispiel hydraulisch, elektromotorisch oder elektromagnetisch betrieben werden.

Die magnetische Klemmeinrichtung 190 weist eine vom Operator 186 zu handhabende Klemmleiste 208 auf, in der ein Hohlraum 210 zur Aufnahme eines Magnetbandes 212 ausgebildet ist. Zum Klemmen des Bogens 174 an seinem Randbereich 194 ist ein Vorsprung 214 vorgesehen, der beim Auflegen der Klemmleiste 208 auf der Auflagefläche des Schlittens 172 von dieser beabstandet ist, so dass eine Aufnahmetasche 216 zur Aufnahme des Randbereichs 194 gebildet ist. Die Klemmleiste 208 ist frei auf dem Schlitten 172, der entsprechend magnetisierbar ist, bewegbar und wird nur über die Magnetkraft des Magnetbandes 212 in ihrer momentanen Position gehalten. Aufgrund der freien Positionierung der Klemmleiste 208 auf dem Schlitten 172 können Bögen 174 mit verschiedenen Ausmaßen sicher auf dem Schlitten 172 lösbar geklemmt werden.

Offenbart ist eine Verlegevorrichtung zum Verlegen von Drahtwicklungen bei Transpondereinheiten mit einer axialen Drahtzuführung zur Verlegevorrichtung, eine Kontaktiervorrichtung zum Kontaktieren der Drähte mit einer selbsttätigen Thermodenklemmanordnung, ein Zustellsystem zum Zustellen von Bearbeitungsvorrichtungen mit einem Piezo-Leg-Motor, eine Herstellungsanlage zur Herstellung von Transpondereinheiten in Konsolenbauweise, ein Verfahren zur Herstellung von Transpondereinheiten mit horizontaler Ultraschalleinleitung und eine Transpondereinheit, bei der die Drahtenden direkt an den Anschlussflächen des Chips angreifen.
- 2: Verlegevorrichtung
- 4: Draht
- 6: Substrat
- 8: Gehäuse
- 10: Ultraschallkonverter
- 12: Sonotrode
- 14: Durchgangsbohrung
- 15: Axialbohrung
- 16: Ringraum
- 17: Ringschulter
- 18: Ringschulterfläche
- 19: Ringschulter
- 20: Ringschulterfläche
- 22: Ausnehmung
- 24: Ausnehmung
- 25: Außenumfangswandung
- 26: Dichtungsring
- 27: Innenumfangswandung
- 28: Umfangsfläche
- 30: Dichtungsring
- 32: Bodenfläche
- 34: Querbohrung
- 36: Konverterhorn
- 38: Schaft
- 40: Zentrierausnehmung
- 41: Zentriervorsprung
- 42: Kopfbereich
- 43: Querbohrung
- 44: Längsbohrung
- 45: Hülse
- 46: Austrittsöffnung
- 47: Glasfaser
- 48: Lagereinrichtung
- 50: Halbkörper
- 52: Halbkörper
- 54: Innenraum
- 56: Eintrittsöffnung
- 58: Radialbohrung
- 60: Radialbohrung
- 62: Vorschubeinrichtung
- 64: Greifer
- 66: Greifer
- 68: Halterung
- 70: Kontaktiervorrichtung
- 72: Klemmanordnung
- 74: Thermode
- 75: Thermodenspitze
- 76: feststehende Klemmbacke
- 78: bewegbare Klemmbacke
- 80: Kopfabschnitt
- 82: Kopfabschnitt
- 84: Feder
- 86: Vertiefung
- 88: Vorsprung
- 90: Backenabschnitt
- 92: Backenabschnitt
- 94: Sackloch
- 96: Sackloch
- 98: Schwenkachse
- 100: Keilelement
- 102: Keilfläche
- 104: Schrägfläche
- 106: Gaskanal
- 108: Gaskanal
- 110: Absaughaube
- 112: Öffnung
- 114: Außenfläche
- 116: Außenfläche

- 117: Verlege- und Kontaktiereinheit
- 118: Verlegevorrichtung
- 119: Sonotrode
- 120: Ultraschallkonverter
- 122: Befestigungskörper
- 123: Schaft
- 124: Zustellsystem
- 126: Längsführung
- 128: Verbindungsschlitten
- 130: Lochmuster
- 132: Grundplatte
- 134: Antrieb
- 136: Finger
- 138: Schieber
- 140: Führungsschulter
- 142: Führungsschlitten
- 144: Längsführung
- 146: Belastungsmesser
- 148: Herstellungsanlage
- 150: Maschinenbett
- 152: Nutzen
- 154: Greifeinrichtung
- 156: Konsole
- 158: Konsole
- 160: Konsole
- 162: Folienstanzstation
- 163: Beschichtungsstation
- 164: Modulstanzstation
- 166: Schneidestation
- 168: Herstellungsanlage
- 170: Zuführung
- 172: Schlitten
- 174: Bogen
- 176: Operator
- 178: Rückführung
- 180: Innenraum
- 182: Kühleinrichtung
- 184: Transpondereinheit
- 186: Auflagefläche
- 188: mechanische Klemmeinrichtung
- 190: magnetische Klemmeinrichtung
- 192: Randbereich
- 194: Randbereich
- 196: Klemmpratze
- 200: Vorspannfeder
- 202: Oberfläche
- 204: Ausnehmung
- 206: Drehschenkel
- 208: Klemmleiste
- 210: Hohlraum
- 212: Magnetband
- 214: Vorsprung
- 216: Aufnahmetasche

## Patentansprüche

1. Zuführsystem einer Bearbeitungsvorrichtung, insbesondere einer Verlegevorrichtung zum Verlegen eines Drahtes auf einem Substrat und/oder Kontaktiervorrichtung zum Kontaktieren des Drahtes mit einem Chip, mit
- ) einem Führungsschlitten (142), der über einen Antrieb (134) entlang einer ersten Längsführung (144) verfahrbar ist, und
- ) einem auf einer zweiten Längsführung (126) geführten und verschiebbaren Verbindungsschlitten (128), an dem die Bearbeitungsvorrichtung befestigbar ist,
**dadurch gekennzeichnet, dass**
der Führungsschlitten (142) über einen Belastungsmesser (146), insbesondere einen Kraftaufnehmer, mechanisch mit dem Verbindungsschlitten (128) verbunden ist, so dass die Bewegung des Führungsschlittens (142) entlang der ersten Längsführung (144) und die Verschiebung des Verbindungsschlittens (128) entlang der zweiten Längsführung (126) im Wesentlichen gleich sind.

2. Zuführsystem nach Anspruch 1, wobei der Belastungsmesser (146) ein DMS-Sensor ist.

3. Zuführsystem nach einem der vorhergehenden Ansprüche, wobei der Antrieb (134) ein Piezo-Motor ist.

4. Zuführsystem nach Anspruch 3, wobei der Piezo-Motor ein Piezo-Leg-Motor ist, der mit zumindest einem verschiebbaren Finger (136) einen mit dem Führungsschlitten (142) zusammen wirkenden Keramikschieber (138), in Zustellrichtung entlang der Längsführung (144) verstellt.

5. Zuführsystem nach einem der vorhergehenden Ansprüche, wobei die Führungsschlittenlängsführung (126) koaxial zur Verbindungsschlittenlängsführung (144) verläuft.

6. Zuführsystem nach einem der vorhergehenden Ansprüche, wobei der Führungsschlitten (142) und der Verbindungsschlitten (128) in einem einzigen Schlitten angeordnet sind.

7. Zuführsystem nach einem der vorhergehenden Ansprüche, wobei der Belastungsmesser (146) dämpfende Eigenschaften hat und eine Überschwingung des Antriebs (134) in Längsrichtung von etwa 100 µm kompensiert.

8. Zuführsystem nach einem der vorhergehenden Ansprüche, wobei über den Belastungsmesser (146) die Verschiebung des Schiebers messbar ist, so dass regelbar in die Steuerung des Piezo-Motors eingegriffen werden kann.
